(19)

Europäisches
Patentamt
European
Patent Office
Office européen
des brevets

(11) **EP 2 759 842 A1**

(12) **EUROPEAN PATENT APPLICATION**

(43) Date of publication:
**30.07.2014 Bulletin 2014/31**

(21) Application number: **13305102.9**

(22) Date of filing: **29.01.2013**

(51) Int Cl.:
**G01R 35/04** (2006.01)  **G01R 15/18** (2006.01)
**G01R 21/133** (2006.01)  **G01R 22/10** (2006.01)
**H01F 27/42** (2006.01)  **H01F 38/32** (2006.01)

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**

(71) Applicant: **Itron France
92130 Issy-Les-Moulineaux (FR)**

(72) Inventor: **Chartouni, Patrick Lionel Joseph
86580 Vouneuil sous Biard (FR)**

(74) Representative: **Shipp, Nicholas
Kilburn & Strode LLP
20 Red Lion Street
London WC1R 4PJ (GB)**

(54) **Method and apparatus for current correction**

(57)    The disclosure relates to a method, apparatus and computer readable medium for compensating for capacitive coupling effects (140) in an inductive current sensor. The method comprises receiving a current of an electrical signal measured at a current sensor at an instant in time. The method further comprises applying a capacitive coupling compensation coefficient to a voltage of the electrical signal measured at a voltage sensor at the instant in time to obtain a capacitive coupling compensation value. Furthermore, the method comprises adjusting the current of the electrical signal using the capacitive coupling compensation value to obtain a compensated current of the electrical signal.

Figure 1

EP 2 759 842 A1

**Description**

**Field of Invention**

This disclosure relates to a means for improving the accuracy of a current sensor. More specifically, but no exclusively, the disclosure provides a method for correcting for the parasitic capacitance present inside an inductive current sensor.

**Background to the Invention**

In electricity metering it is necessary to accurately measure the current and voltage of the power drawn from the electrical grid in order to ensure that the metering is accurate.

DC polyphase meters often use isolated current sensors such as inductive sensors based on the Rogowski loop principle. Itron Inc. has been using their own inductive current sensor named MCT for Mutual Current Transformer as disclosed in French patent FR2849925B1 and also uses a new generation of Rogowski loops for their meters similar to those presented in the European patent EP2009453B1. These inductive current sensors have a low sensitivity, for example in the region of tens of μV per Amp at 50 or 60Hz for the Rogowski loop and some of mV per Amp at 50 or 60Hz for the MCT sensor. However, the output signal of such meters can be easily perturbed by other signals at the same frequency superimposed on the output signal due to a capacitive coupling effect between the phase (primary conductor of the sensor) and the secondary pick-up coil of the sensor. This capacitive coupling is the consequence of the presence of the two conductors close to each other; the first conductor is a primary conductor of the sensor and the second one is a secondary pick up coil of the sensor. These two conductors are separated by an isolation material. The characteristics of the isolation material and the geometry of the sensors determine the capacitance between the primary and the secondary conductors of the sensor.

Various solutions to this problem have already been presented. First, hardware solutions have been presented in which an electrostatic shield is incorporated inside the sensor. Such a shield prevents the direct coupling of a parasitic voltage signal on the secondary pick-up coil. However, incorporation of such an electrostatic shield into a sensor increases the device cost, which is undesirable. Secondly, meters have been made with a reduced dynamic range, which in turn reduces the influence of the parasitic capacitance However, this second solution is only suitable for meters operating at high currents and therefore represents only a limited solution to the problem, because the meter has ipso facto a limited possibility to measure a small amount of energy at low current. Consequently, the solutions presented to date have not adequately solved the problem.

**Summary of Invention**

Embodiments of the present invention attempt to mitigate at least some of the above-mentioned problems.

In accordance with an aspect of the invention there is provided a method for compensating for capacitive coupling effects in an inductive current sensor. The method comprises receiving a current of an electrical signal measured at a current sensor at an instant in time. The method also comprises applying a capacitive coupling compensation coefficient to a voltage of the electrical signal measured at a voltage sensor at the instant in time to obtain a capacitive coupling compensation value. Furthermore, the method comprises adjusting the current of the electrical signal using the capacitive coupling compensation value to obtain a compensated current of the electrical signal.

The step of adjusting the current of the electrical signal may comprise subtracting the capacitive coupling compensation value from the current of the electrical signal.

The current sensor may be an inductive current sensor comprising a first conductor associated with the electrical signal and a second conductor electrically isolated from the first conductor, wherein an electrical signal may be induced in the second conductor due to the electrical signal in the first conductor.

The capacitive coupling compensation value may be a value indicative of a voltage erroneously induced on the second conductor of the current sensor due to capacitive effects between the first and second conductor.

The coupling compensation coefficient may be determined in accordance with the result of the capacitive coupling voltage divided by the difference in voltage between the voltage on the first conductor of the current sensor and a reference voltage.

The capacitive coupling compensation coefficient, Kcoup, may be determined in accordance with the following equation:

$$\mathbf{Kcoup.} = \frac{\text{Icoup.} * (\text{Nb LSB/A})}{\text{Un} * (\text{Nb LSB/V})}$$

Icoup is the value of coupling expressed in terms of a current (A). Un is a nominal value of the voltage of the LV network between phase and neutral ; Nb LSB/A is the number of the numerical code for one Ampere. LSB means the Least Significative Bit. This is the numerical value for example under 16bits of one Amp. Nb LSB/V is the number of the numerical code for one Volt. This is the numerical value for example under 16bits of one Volt (16bit = 65536 codes).

The method may further comprise measuring the current at the current sensor. The method may also further comprise determining a power from the compensated current and the voltage.

The current sensor may form part of an electricity meter.

In accordance with another aspect of the invention apparatus for compensating for capacitive coupling effects of current sensors is provided. The apparatus may comprise a processor arranged to perform any method as discussed herein. The apparatus may be an electricity meter.

In accordance with another aspect of the invention a computer readable medium is provided comprising computer readable code operable, in use, to instruct a computer to perform any method as discussed herein.

Embodiments of the invention provide an accurate compensation for perturbations resulting from parasitic capacitance. The compensation process performed by the metrology of firmware utilises voltage present on a primary phase electrical signal. A benefit of such dynamic compensation is to obtain the best linearity error accuracy for current measurements and consequently for metrology calculations using current as apparent, active and reactive energies in all the quadrants (lag and lead for export and import), and related quantities such as Irms. Embodiments of the invention calculate a compensation value on each current sample for each phase of a three phase system (IPhase1, IPhase2, IPhase3) in real time at the sampling frequency (fs). The compensation consists of subtracting a portion of the value of the voltage samples (VPhase1, VPhase2, VPhase3) from the current. After having characterized the capacitive coupling amplitude for a certain type of inductive current sensor the portion of the voltage error superimposed to the current measurement is a very small signal equivalent to around some thousandths of the output signal of the current sensor at the base current Ib.

In embodiments of the invention, the intrinsic capacitive coupling between the primary phase of a current sensor and the secondary pick up coil of the current sensor represent the equivalent of some mA at 50 or 60Hz and low voltage on primary side for the MCT sensor and some hundreds of mA at 50 or 60Hz and low voltage on primary side for the Rogowski loop. The innovative algorithm is therefore able to suppress this error in all the quadrants of the Fresnel representation of the voltage and current of the grid.

Embodiments of the invention provide an improvement of the metrology firmware for DC polyphase meters permitting to obtain a quasi-perfect linearity in terms of energy from the starting current to the maximum current measured by the meter.

The linearity curves presented in accordance with embodiments of the invention show excellent results over all of the range of currents from a starting current of 1.2A to a maximum current of 3000A for the Rogowski loop. For DC polyphase meters using the MCT sensor excellent results can be seen over all of the range of currents from a starting current of some tens of mA to a maximum current of 100A. A linearity curve may therefore be extended flat from the starting current to the maximum current.

Embodiments of the invention provide a significant enlargement of the linearity curves at low current for active and reactive energies in all four quadrants of a Fresnel representation (Q1,Q2,Q3,Q4), that is for active import or export and reactive import or export, lag and lead.

Advantageously, embodiments of the invention provide a means for compensating for parasitic capacitances in an inductive current sensor that introduces no additional financial costs to a meter in which the current sensor is included. Furthermore, such embodiments of the invention reduce the time of verification of metrology after calibration. This is achieved by performing compensation processing within the firmware of the meter.

**Brief Description of the Drawings**

Exemplary embodiments of the invention shall now be described with reference to the drawings in which:

Figure 1 provides a magnetostatic and electrostatic model of a MCT current sensor in accordance with an embodiment of the invention;
Figure 2 illustrates a current and voltage detection and calculation process performed by an electricity meter, wherein the current is detected using an inductive current sensor like that of Figure 1;

Figure 3 provides examples of the characterization of the coupling on active energy curves for a three-phase DC meter;

Figures 4 provides results of tests on a Galvani polyphase DC meter without using the process of Figure 2;

Figure 5 provides results of tests on a Galvani polyphase DC meter using the process of Figure 2;

Figure 6 provides a linearity curve of the results of Figure 4 and Figure 5 for four MCT sensors at power factor equal to 1 (PF1);

Figure 7 provides a linearity curve of the results of Figure 4; and Figure 5 for four MCT sensors at power factor equal to 0,5 (PF0,5);

Figure 8 shows the principle of the Rogowski loop inductive current sensor;

Figure 9 provides a linearity curve associated with sensing current using the Rogowski loop current sensor shown in Figure 8 without an electrostatic shield between the primary conductor and the secondary pick-up coil; and

Figure 10 provides an alternative linearity curve associated with sensing current using the Rogowski loop current sensor shown in Figure 8 with an electrostatic shield between the primary conductor and the secondary pick-up coil, but without firmware compensation of the capacitive coupling.

Throughout the description and the drawings, like reference numerals refer to like parts.

**Specific Description**

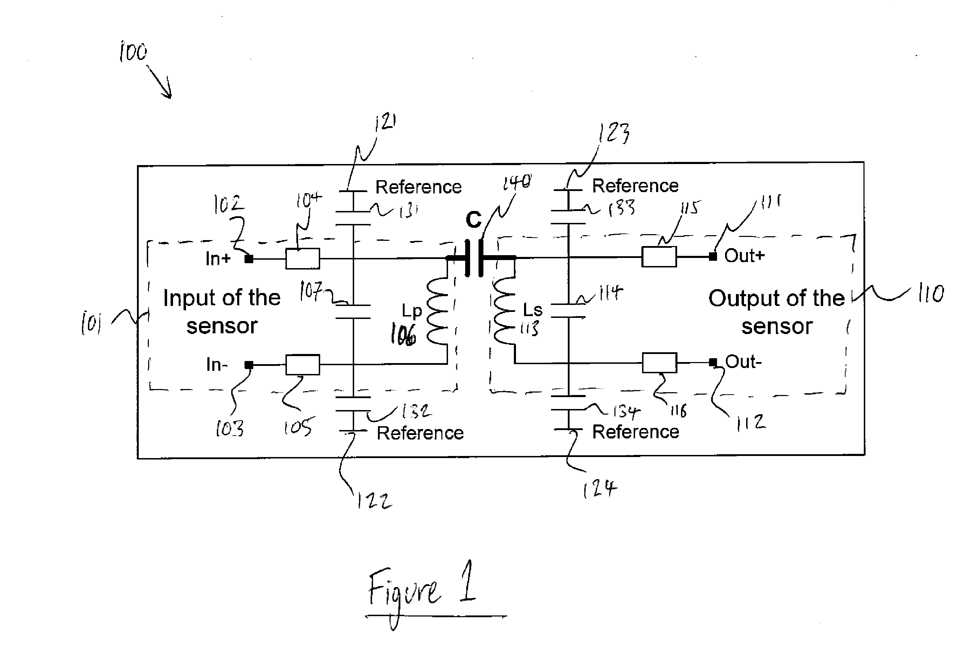

Figure 1 provides a magnetostatic and electrostatic model 100 of a Mutual Current Transformer inductive current sensor (MCT) provided in accordance with an embodiment of the invention. The MCT sensor modeled in Figure 1 is operable within a frequency range of 1Hz to 100 kHz.

The sensor is an inductive current sensor comprising an input circuit 101 having positive and negative terminals 102, 103 through which the primary current (phase current) to be sensed flows. The current flowing through the input circuit 101 passes through an inductor or primary bus bar Lp, 106, which produces an electromagnetic field. The input circuit 101 has a resistance as shown by resistors 104 and 105 in Figure 1. A transversal capacitance exists between the input terminals 102, 103, as shown by capacitor 107. This capacitance is like the capacitance shown by capacitor 114, the end to end capacitance; in other words it is the parallel capacitance added in a high frequency model of a coil.

An output circuit 110 of the sensor includes positive and negative terminals 111, 112 along with an inductor or pick-up coil 113 placed between those terminals. The electromagnetic field produced by the inductor 107 of the input circuit 101 induces a voltage in the inductor 113 of the output circuit 110; the induced voltage is then used by the meter metrology firmware to determine the current in the input circuit 101. A transversal capacitance also exists between the output terminals 111, 112 as shown by capacitor 114. Furthermore, the output circuit 110 has a resistance as shown by resistors 115 and 116 in Figure 1.

Both the input circuit 101 and output circuit 110 are held between a reference voltage provided by the terminals 121, 122, 123, 124 and the corresponding stray capacitance 131, 132, 133, 134. The reference voltage is the reference potential of the analog electronics of the electricity meter. Normally for a polyphase meter with three phases and neutral, the reference potential is the neutral in the case of a MCT sensor, the magnetic shield is connected to the reference and stray capacitance may exist between the primary conductor and the shield as well as between the secondary conductor and the shield. The absolute value of these capacitances is much smaller than a coupling capacitance (140) that exists between the primary conductor (106) and the secondary coil (113), as discussed below.

The capacitance present between the two inductors 106, 113 shown by the capacitor 140 in Figure 1 is a capacitive coupling, which is the consequence of the presence of the two conductors being close to each other. The first conductor is the primary conductor and the second conductor is the secondary pick-up coil. These two conductors are separated by an isolation material; the characteristics of the isolation material and the geometry of the sensors determine the value of the capacitance between the primary and the secondary conductors. This parasitic capacitance results in voltage being coupled in the output circuit, in addition to the voltage already coupled in the output circuit resulting from the electromagnetic induction and purely representative of the primary current to be measured. Consequently, the parasitic capacitance introduces an erroneous voltage in the output circuit 110, which skews the signal measurement. While the parasitic capacitance is of a magnitude of hundred times lower than that of the main mutual inductance (primary - secondary), this is still an unwanted error. As will be discussed, embodiments of the invention correct for this error.

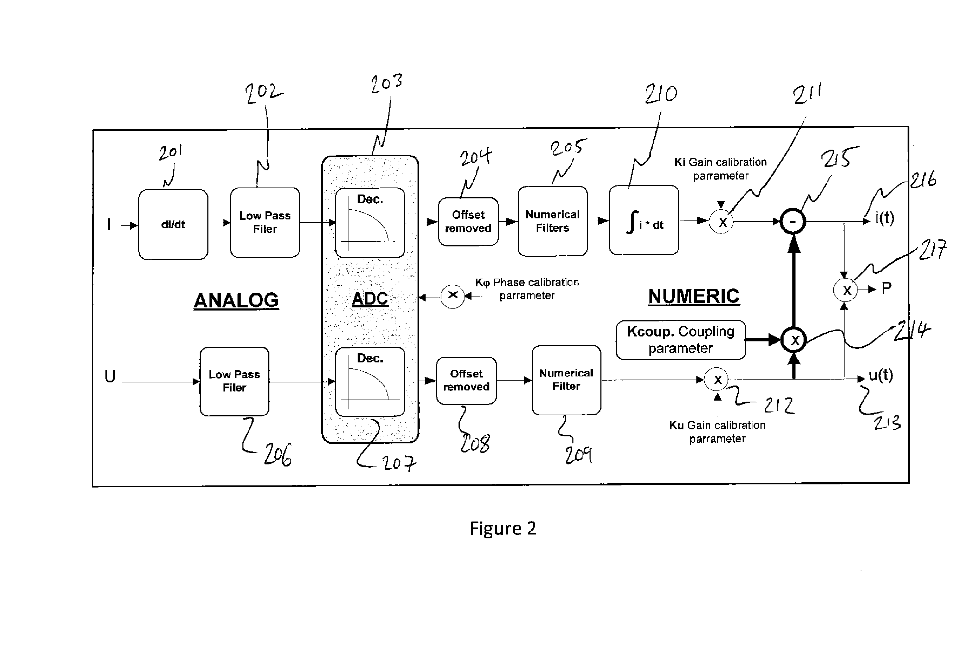

In this embodiment of the invention, a compensation for the parasitic capacitance is calculated on each current sample for each phase (e.g. IPhase1, IPhase2, IPhase3) in real-time at a sampling frequency, fs. This process will be explained in more detail with reference to Figure 2.

Figure 2 illustrates a current and voltage detection process performed by an electricity meter, wherein the current is detected using the current sensor of Figure 1.

First, the current I and voltage U are measured, using respective sensing means. The current for each phase is measured by an inductive current sensor, such as that shown in Figure 1. The output voltage of the sensor is of hundreds of millivolts, which is compatible with an analog-to-digital input stage. The difference in voltage between each phase and the neutral, is obtained by a resistive divider. The high value of some hundred volts between phase and neutral is reduced to hundreds of millivolts, which is also compatible with Analog to Digital input stage.

Block 201 represents the current sensor, which in this case is an inductive current sensor which is a derivative sensor. The output of block 201 is then passed through a low pass filter 202 to reduce undesirable amplified signals at frequencies in a frequency band from 2 kHz to 100 kHz. Since the inductive current sensor is a derivative sensor, the output signal of the sensor is proportional to the amplitude of the primary current and to the frequency of the primary current. It is therefore clear that higher frequency components of the primary currents have to be filtered. The measured voltage U is also passed through a low pass filter 206. The characteristics of the low pass filter are identical to those of block 202 to thereby obtain the same phase shift for the current measurement and the voltage measurement over the same frequency band.

Both the analog filtered current and voltage measurement are then converted to digital data using respective analogue-to-digital converters (ADC) or the same multichannel ADC. Such a multichannel ADC includes numerical decimator filters represented by blocks 203, 207.

The ADC utilizes a phase calibration parameter. The phase calibration parameter is used by the ADC to compensate for a time delay between the sampled current signal and the sampled voltage signal, this correction helps to reduce the error in the active energy by correcting the value of $\cos(\varphi)$, where $\varphi$ is the phase between the fundamental current and the fundamental voltage.

The digital current and voltage then have their respective offsets removed at blocks 204 and 208 respectively. Blocks 204 and 208 suppress the DC component of the numerical sampling on both the voltage and current channels. Furthermore, the outputs of blocks 203 and 207 are then passed through numerical filter 205 and 209 respectively. These two numerical filters are used to equalize the analog frequency response over the frequency measurement bandwidth for example from 50Hz to 650Hz (13th harmonic of the 50Hz).

The current output by numerical filter 205 is then integrated using integrator 210 to reconstitute the original current waveform. Since the current sensor is a derivative component, the numerical data has to be integrated.

The output of integrator 210 is then subjected to a gain calibration parameter Ki at multiplier 211. The voltage output of filter 209 is also subjected to a gain calibration parameter Ku at multiplier 212. The gain calibration parameters Ki and Ku are necessary to correct the error in amplitude of the current sensor and the resistive divider of the voltage sensor. In other words, Ku and Ki correct the tolerance of these components of the respective sensors.

The calibrated voltage is the determined output voltage u(t) used for determining the electricity metrology quantities Urms , active and reactive and apparent power and energies.

The final output voltage u(t) is then utilized to correct the raw current samples in order to correct the error resulting from the parasitic voltage coupling inside the current sensor. The voltage samples are known to be correct in terms of both phase and amplitude because no external influence can affect the measurement of voltage when voltage is measured using a resistive divider and the tolerance of the divider has been corrected by coefficient Ku compared to a reference meter.

The correction of the capacitive coupling is performed by multiplying the sample of voltage u(t) by a coupling parameter Kcoup at multiplier 214, the output of which is then subtracted from the current sample by multiplier 211 at subtractor 215. In other words, the error signal due to the parasitic capacitance is approximated by the combination of the output voltage u(t) and the parameter Kcoup.

This compensation method shall now be described in more detail.

The output signal of the inductive current sensor can be represented as shown by Equation 1:

$$\text{Vsensor(t)} = (M * \frac{dIph(t)}{dt}) + j * (R * C * 2\pi * f) * Vph(t)$$

*Equation 1*

Wherein Vsensor(t) is the output signal of the inductive sensor, Iph(t) is the primary current, Vph(t) is the difference in the voltage between the primary conductor of the current sensor and the reference, $M(\mu H)$ is the mutual inductance between the primary conductor (phase) and the secondary pick up coil, $C (\mu F)$ is the coupling capacitance between the primary conductor (phase) and output pin of the secondary pick up coil, R is the resistive part of the secondary coil, and f(Hz) is the main frequency, the nominal frequency being 50/60Hz.

Equation 1 indicates the two signals combined in the sensor output. These signals are measured current, as shown by Equation 2; the first term is the mutual inductance of the sensor multiplied by the derivative of the primary current:

$$V1\ sensor(t) = j*(M*2\pi*f)*Iph(t)$$

*Equation 2*

And the second term is the error due to the voltage caused by the capacitive coupling, V2 sensor(t) as shown by Equation 3:

$$V2\ sensor(t) = j*(R*C*2\pi*f)*Vph(t)$$

*Equation 3*

After being integrated in block 210, the two components are representative of measured quantities, first the current measured without error:

$$I1(t) = M*Iph(t)$$

*Equation 4*

And secondly, the term of error:

$$I2(t) = R*C*Vph(t)$$

*Equation 5*

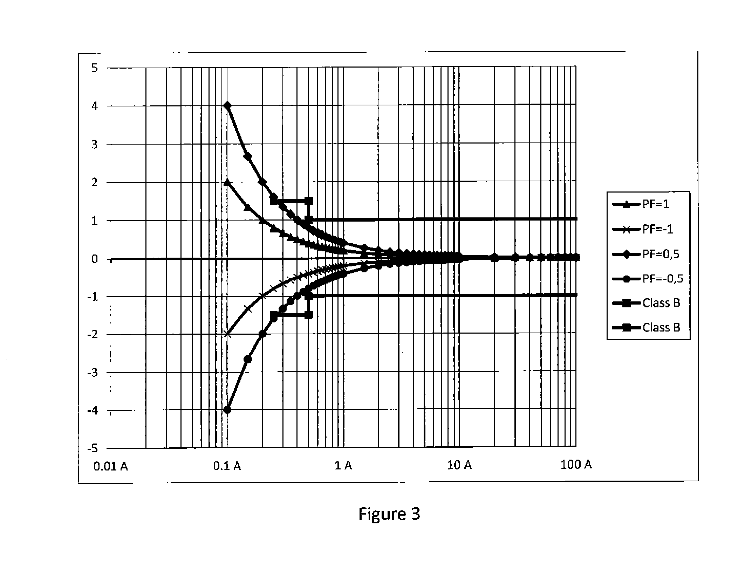

The term of the error is directly proportional to the voltage. Furthermore, the voltage resulting from the parasitic capacitance in the sensor is dependent on both the geometry of the sensor and the dielectric permittivity of the isolation material used between primary conductor and secondary pick up coil. The parasitic capacitance is in the region of picoFarads (pF) and can be evaluated and compensated for with a defined value with a very limited risk of dispersion among a large number of sensors as can be seen in Figure 3, which provides examples of the characterization of the coupling on active energy curves for a three-phase DC meter

The linearity curves of Figure 3 show the influence of the voltage coupling on the linearity of the active energy import and export at different power factors (PF). The value of the coupling is estimated directly by the error for a given current at a given voltage and frequency. In the example shown by Figure 3 a coupling current of 2mA (PF1) is provided at 230Vrms - 50Hz; meaning that an error of +2% is present at 100mA for import direction and an error of -2% at 100mA for export direction.

Equation 5 can be written to replace the product R*C by a parameter Kcoup, as shown by Equation 6:

$$I2\ (t) = Kcoup*Vph(t)$$

*Equation 6*

The parameter Kcoup is therefore determined experimentally as follows:

$$\mathbf{Kcoup.} = \frac{\text{Icoup.} * (\text{Nb LSB/A})}{\text{Un} * (\text{Nb LSB/V})}$$

*Equation 7*

Kcoup is a parameter value to be programmed into the meter obtained experimentally from the linearity curve of a meter using the current sensor and without capacitive compensation, Icoup is a number representative of the equivalent current producing the error of linearity as measured, for example an error of 2% at 0.1A would result in a Icoup of 2mA, Un is a number representative of the nominal difference of voltage between the primary conductor of the sensor and the reference , Nb LSB/A is the number of the numerical code for one Ampere, LSB means the Least Significative Bit, this is the numerical value for example under 16bits of one Amp, Nb LSB/V is the number of the numerical code for one Volt, LSB means the Least Significative Bit , this is the numerical value for example under 16bits of one Volt (16bit = 65536 codes).

The processing carried out by blocks 214 and 215 of Figure 2 to obtain the corrected current can then be presented as shown in Equation 8:

$$i(t) = is(t) - Kcoup. * Vph(t)$$

*Equation 8*

Wherein is(t) is the raw current sample, and i(t) is the corrected current sample by subtraction of the error term.

Equation 8 allows for dynamic compensation of the current by subtracting the value of the voltage sample Vph(t) multiplied by Kcoup from the raw value of the current sample is(t).

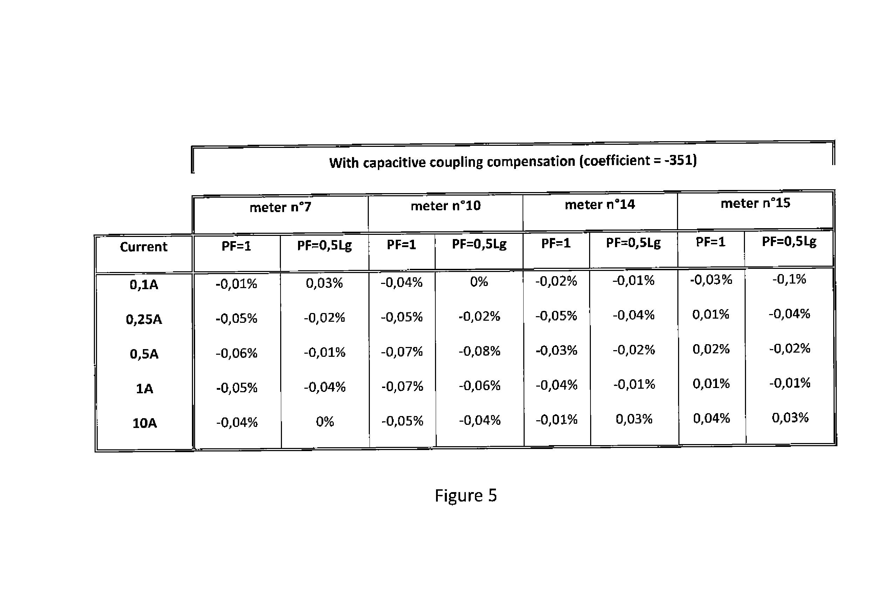

Figures 5, 6, and 7 are examples of use of the above-described compensation method on a Galvani polyphase DC electricity meter from ITRON residential electricity range. The current sensors used in such polyplase meters are on each phase MCT.

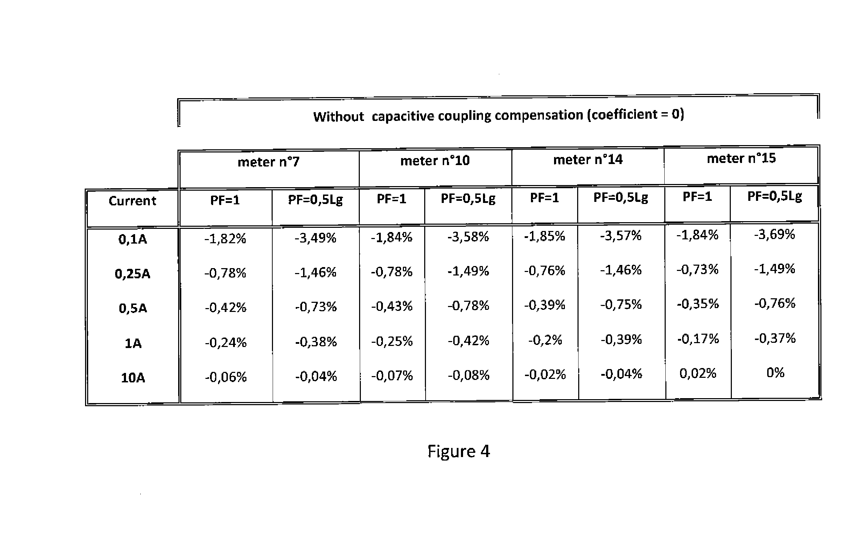

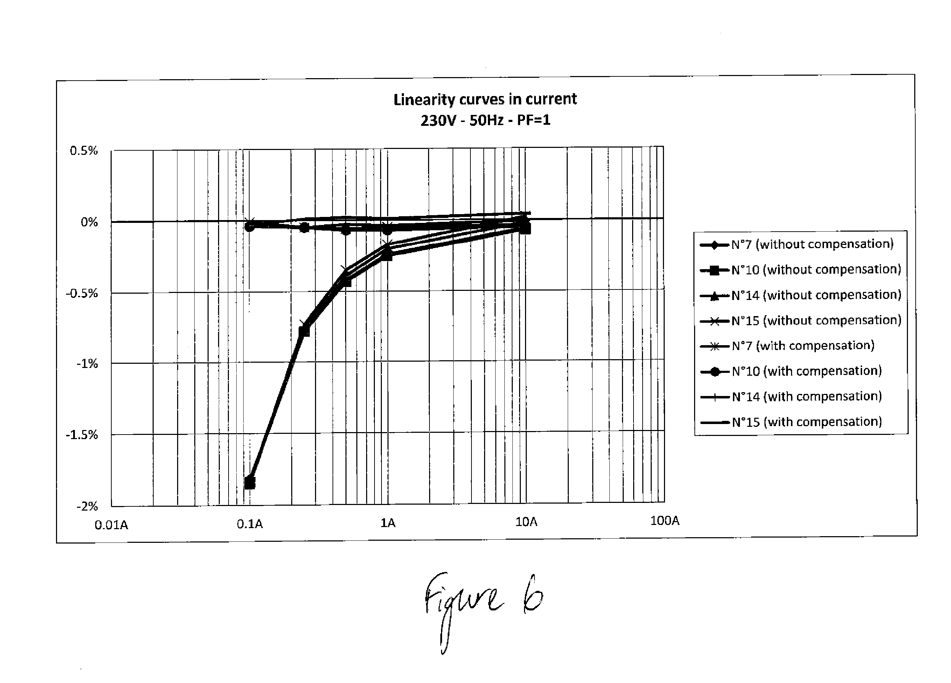

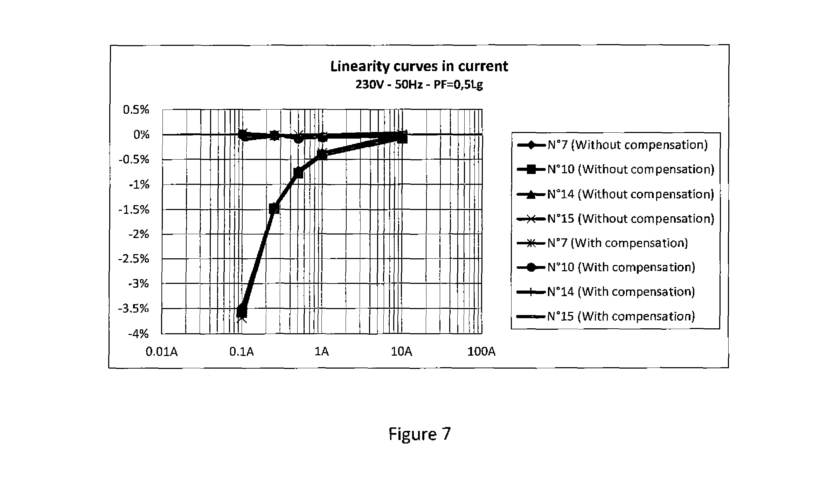

Firstly, as shown in Figure 4, tests were carried out on four electricity meters (meters 7, 10, 14 and 15) without use of any capacitive coupling compensation. Then, as shown in Figure 5, tests were done on the same four electricity meters using the capacitive coupling compensation method disclosed herein. Figures 6 and 7 show the linearity curves with and without compensation at PF1 import and PF0.5 import respectively.

From Figures 4 to 7 it can be seen that the intrinsic capacitive coupling between the primary phase of the current sensor and its output signal represent the equivalent of 1.84mA (PF -1). The parasitic capacitance generates a metrological linearity error of -1.89% at 100mA PF1, and a value multiplied by a factor 2 (-3,69%) at the same current (100mA) at PF0.5. However, the process disclosed herein suppresses this error at PF1 and PF0.5. Consequently, the linearity curves remain excellent over all of the current range from 100mA to 10A. This linearity curve can be extended to the starting current with an excellent accuracy when utilizing the compensation process disclosed herein.

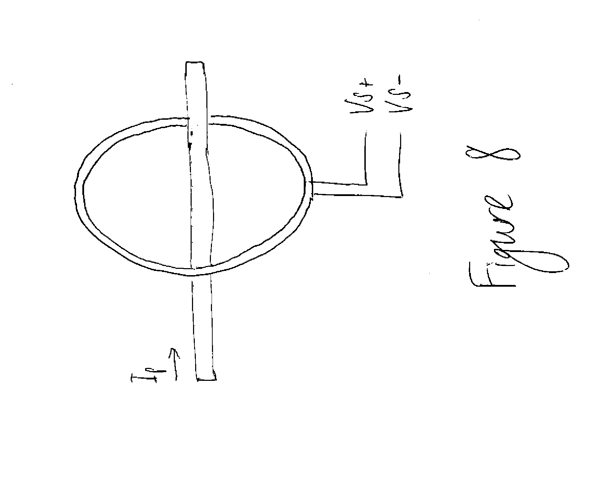

Figure 8 relates to an alternative embodiment of the invention wherein a Rogowski loop based current sensor is utilized. This sensor is a thin coil 301 directly positioned around the conductor carrying a current to be measured. The sensitivity of the sensor is particularly low, some tens of μV per Amp at 50Hz. This inductive sensor is equivalent to a mutual inductance between the primary conductor passing through the secondary pick up coil.

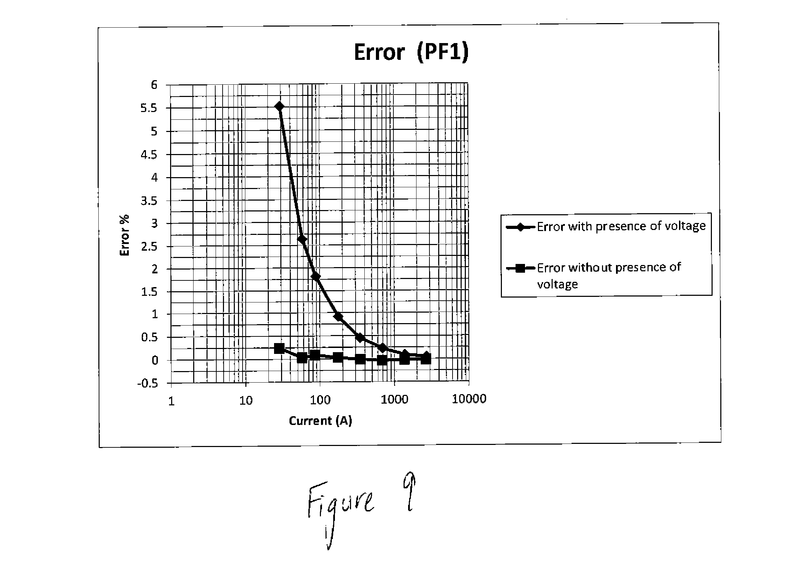

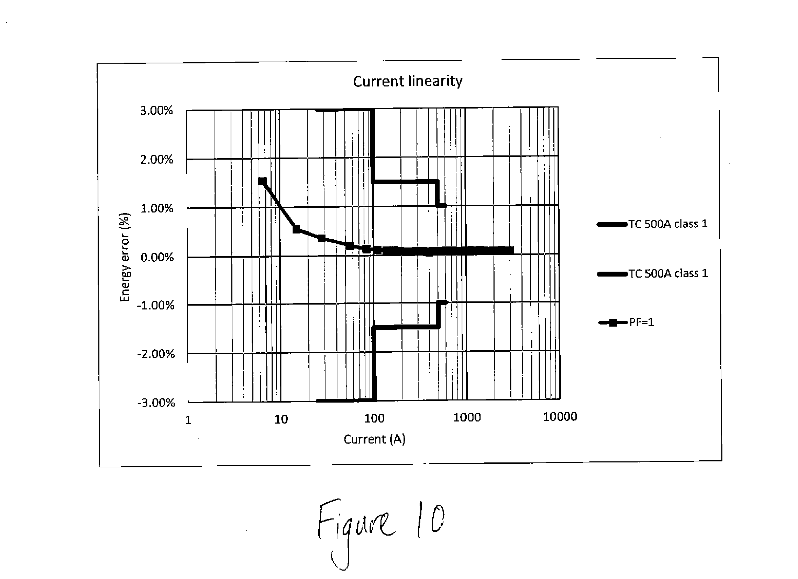

The capacitive coupling between the primary conductor at 230V 50Hz is easily measured at low current as shown by the linearity curve of Figure 9. An error of +5.5% at 30Arms (PF1) indicates a capacitive coupling equivalent to 1,65Arms (PF1). A small amount of capacitive coupling still exists in the sensor and is visible on the linearity curve as shown by Figure 10. The curve indicates that the remaining coupling error is +1% at 10A (equivalent to 100mA), the reduction of the capacitive coupling obtained by the electrostatic shield around the Rogowski coil is 1.65A/0.1A = 16.5.

For the sensor shown in Figure 8, with a variable geometry of the primary busbar, particularly the distance between live parts (phase wires) and the coil, the compensation parameters can be adjusted proportionally to the total cross section of the LV wires proportional to the maximum current of the conductor. This is because the parasitic capacitance effect is inversely proportional to the distance between the phase conductor passing through the sensor loop and the secondary pick-up coil .

If the sensor is a Rogowski loop for a meter with a metrology Ibase = 300A (Imax = 3000A), the coupling signal at 230V -50Hz is equivalent to 100mArms = Ib/3000. This amount of error represents directly some percentage of error on the active energies. For the MCT DC the coupling signal of 1.9mArms introduce an error of 3.8% at 50mA = Ib/ 100.

For Rogowski loop the coupling signal of 100mArms introduce an error of 3,3% at 3A = Ib/ 100

In alternative embodiments of the invention that utilise Ip link contacts, the compensation method is arranged to come into operation when the Ip link is closed so that the algorithm of compensation is operable.

The various methods described above may be implemented by a computer program. The computer program may include computer code arranged to instruct a computer to perform the functions of one or more of the various methods described above. The computer program and/or the code for performing such methods may be provided to an apparatus, such as a computer, on a computer readable medium. The computer readable medium could be, for example, an electronic, magnetic, optical, electromagnetic, infrared, or semiconductor system, or a propagation medium for data transmission, for example for downloading the code over the Internet. Non-limiting examples of a physical computer readable medium include semiconductor or solid state memory, magnetic tape, a removable computer diskette, a random access memory (RAM), a read-only memory (ROM), a rigid magnetic disc, and an optical disk, such as a CD-ROM, CD-R/W or DVD. The computer may be a smart meter having computing functionalities, such as a processor to perform the method and a memory to store information necessary to perform the method.

**Claims**

1. A method for compensating for capacitive coupling effects in an inductive current sensor, the method comprising:

   receiving a current of an electrical signal measured at a current sensor at an instant in time;
   applying a capacitive coupling compensation coefficient to a voltage of the electrical signal measured at a voltage sensor at the instant in time to obtain a capacitive coupling compensation value; and
   adjusting the current of the electrical signal using the capacitive coupling compensation value to obtain a compensated current of the electrical signal.

2. The method according to claim 1, wherein the step of adjusting the current of the electrical signal comprises subtracting the capacitive coupling compensation value from the current of the electrical signal.

3. The method according to claim 1 or claim 2, wherein the current sensor is an inductive current sensor comprising a first conductor associated with the electrical signal and a second conductor electrically isolated from the first conductor, wherein an electrical signal is induced in the second conductor due to the electrical signal in the first conductor.

4. The method according to claim 3, wherein the capacitive coupling compensation value is a value indicative of a voltage erroneously induced on the second conductor of the current sensor due to capacitive effects between the first and second conductor.

5. The method according to claim 3 or claim 4, wherein the coupling compensation coefficient is determined in accordance with the result of the capacitive coupling voltage divided by the difference in voltage between the voltage on the first conductor of the current sensor and a reference voltage.

6. The method according to any preceding claim, wherein the capacitive coupling compensation coefficient, Kcoup, is determined in accordance with the following equation:

$$\text{Kcoup.} = \frac{\text{Icoup.} * (\text{Nb LSB/A})}{\text{Un} * (\text{Nb LSB/V})}$$

   Wherein Icoup is the value of coupling expressed in terms of a current (A), Un is a nominal value of the voltage of the LV network between phase and neutral; Nb LSB/A is the number of the numerical code for one Ampere, LSB means the Least Significative Bit, this is the numerical value for example under 16bits of one Amp, Nb LSB/V is the number of the numerical code for one Volt, LSB means the Least Significative Bit , this is the numerical value for example under 16bits of one Volt (16bit = 65536 codes).

7. The method according to any preceding claim, further comprising measuring the current at the current sensor.

8. The method according to any preceding claim, further comprising determining a power from the compensated current and the voltage.

9. The method according to any preceding claim, wherein the current sensor forms part of an electricity meter.

10. Apparatus for compensating for capacitive coupling effects of current sensors, the apparatus comprising a processor arranged to perform the method of any preceding claim.

11. The apparatus according to claim 10, wherein the apparatus is an electricity meter.

12. A computer readable medium comprising computer readable code operable, in use, to instruct a computer to perform the method of any one of claims 1 to 9.

Figure 1

Figure 2

Figure 3

**Without capacitive coupling compensation (coefficient = 0)**

| Current | meter n°7 | | meter n°10 | | meter n°14 | | meter n°15 | |
|---|---|---|---|---|---|---|---|---|
| | PF=1 | PF=0,5Lg | PF=1 | PF=0,5Lg | PF=1 | PF=0,5Lg | PF=1 | PF=0,5Lg |
| 0,1A | -1,82% | -3,49% | -1,84% | -3,58% | -1,85% | -3,57% | -1,84% | -3,69% |
| 0,25A | -0,78% | -1,46% | -0,78% | -1,49% | -0,76% | -1,46% | -0,73% | -1,49% |
| 0,5A | -0,42% | -0,73% | -0,43% | -0,78% | -0,39% | -0,75% | -0,35% | -0,76% |
| 1A | -0,24% | -0,38% | -0,25% | -0,42% | -0,2% | -0,39% | -0,17% | -0,37% |
| 10A | -0,06% | -0,04% | -0,07% | -0,08% | -0,02% | -0,04% | 0,02% | 0% |

Figure 4

| | With capacitive coupling compensation (coefficient = -351) | | | | | | | |
|---|---|---|---|---|---|---|---|---|
| | meter n°7 | | meter n°10 | | meter n°14 | | meter n°15 | |
| Current | PF=1 | PF=0,5Lg | PF=1 | PF=0,5Lg | PF=1 | PF=0,5Lg | PF=1 | PF=0,5Lg |
| 0,1A | -0,01% | 0,03% | -0,04% | 0% | -0,02% | -0,01% | -0,03% | -0,1% |
| 0,25A | -0,05% | -0,02% | -0,05% | -0,02% | -0,05% | -0,04% | 0,01% | -0,04% |
| 0,5A | -0,06% | -0,01% | -0,07% | -0,08% | -0,03% | -0,02% | 0,02% | -0,02% |
| 1A | -0,05% | -0,04% | -0,07% | -0,06% | -0,04% | -0,01% | 0,01% | -0,01% |
| 10A | -0,04% | 0% | -0,05% | -0,04% | -0,01% | 0,03% | 0,04% | 0,03% |

Figure 5

Linearity curves in current
230V - 50Hz - PF=1

N°7 (without compensation)
N°10 (without compensation)
N°14 (without compensation)
N°15 (without compensation)
N°7 (with compensation)
N°10 (with compensation)
N°14 (with compensation)
N°15 (with compensation)

figure 6

Figure 7

Figure 8

**Error (PF1)**

Figure 9

EP 2 759 842 A1

Figure 10

Europäisches
Patentamt

European
Patent Office

Office européen
des brevets

# EUROPEAN SEARCH REPORT

Application Number

EP 13 30 5102

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | DANIEL SLOMOVITZ ET AL: "Error compensation of capacitive effects in current transformers", PRECISION ELECTROMAGNETIC MEASUREMENTS (CPEM), 2012 CONFERENCE ON, IEEE, 1 July 2012 (2012-07-01), pages 158-159, XP032210974, DOI: 10.1109/CPEM.2012.6250721 ISBN: 978-1-4673-0439-9 * the whole document * | 1-12 | INV. G01R35/04 G01R15/18 G01R21/133 G01R22/10 H01F27/42 H01F38/32 |
| A | HARTMANN M ET AL: "Wideband Current Transducer for Measuring AC Signals With Limited DC Offset", IEEE TRANSACTIONS ON POWER ELECTRONICS, IEEE SERVICE CENTER, PISCATAWAY, NJ, US, vol. 24, no. 7, 1 July 2009 (2009-07-01), pages 1776-1787, XP011272402, ISSN: 0885-8993, DOI: 10.1109/TPEL.2009.2017263 * paragraphs [IIA2], [0IVC]; figure 7 * | 1-12 | |
| A | US 2010/145642 A1 (SLOTA FREDERICK BLAIR [US] ET AL SLOTA FREDERICK B [US] ET AL) 10 June 2010 (2010-06-10) * paragraphs [0007] - [0013], [0023], [0027] - [0028] * | 1-12 | TECHNICAL FIELDS SEARCHED (IPC) G01R H01F |
| A | US 2007/200552 A1 (FRITZ GERHARD [AT]) 30 August 2007 (2007-08-30) * paragraphs [0059] - [0060], [0066] - [0068], [0075], [0078] - [0079]; figure 1 * | 1-12 | |

The present search report has been drawn up for all claims

| Place of search | Date of completion of the search | Examiner |
|---|---|---|
| Munich | 18 July 2013 | Maric, Viktor |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**ANNEX TO THE EUROPEAN SEARCH REPORT
ON EUROPEAN PATENT APPLICATION NO.**

EP 13 30 5102

This annex lists the patent family members relating to the patent documents cited in the above-mentioned European search report.
The members are as contained in the European Patent Office EDP file on
The European Patent Office is in no way liable for these particulars which are merely given for the purpose of information.

18-07-2013

| Patent document cited in search report | Publication date | Patent family member(s) | Publication date |
|---|---|---|---|
| US 2010145642 A1 | 10-06-2010 | US 2006085144 A1<br>US 2008125986 A1<br>US 2010145642 A1 | 20-04-2006<br>29-05-2008<br>10-06-2010 |
| US 2007200552 A1 | 30-08-2007 | DE 102004010707 A1<br>EP 1723435 A1<br>US 2007200552 A1<br>WO 2005085881 A1 | 22-09-2005<br>22-11-2006<br>30-08-2007<br>15-09-2005 |

EPO FORM P0459

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- FR 2849925 B1

- EP 2009453 B1